# EUROPEAN PATENT SPECIFICATION

(11) **EP 2 347 642 B1**
(45) Date of publication and mention of the grant of the patent: **17.04.2013**
(21) Application number: 08876277.8
(22) Date of filing: 03.11.2008
(51) Int. Cl.: H05K 7/20, F28D 15/02, F28D 15/06

(54) **A SYSTEM IN A NETWORK NODE FOR REGULATING TEMPERATURE OF ELECTRONIC EQUIPMENT**
SYSTEM IN EINEM NETZWERKKNOTEN ZUM REGELN DER TEMPERATUR VON ELEKTRONISCHEN GERÄTEN
SYSTÈME DANS UN N UD DE RÉSEAU PERMETTANT DE RÉGULER LA TEMPÉRATURE D'UN ÉQUIPEMENT ÉLECTRONIQUE

(43) Date of publication of application: 27.07.2011
(73) Proprietor: Telefonaktiebolaget L M Ericsson (publ), 164 83 Stockholm (SE)
(72) Inventor: HEDBERG, Klas, S-141 38 Huddinge (SE)
(74) Representative: Kühn, Friedrich Heinrich
(86) International application number: PCT/SE2008/051252
(87) International publication number: WO 2010/050866

(56) References cited:
- WO-A1-99/30091
- DE-A1- 4 108 981
- US-A1- 2003 205 364

## Description

### TECHNICAL FIELD

The present invention relates to a system in a radio network node, more particularly, to a system in a radio network node for regulating temperature of electronic equipment within the radio network node. Moreover, the present invention relates to an arrangement for restricting flow in a heat exchanger unit.

### BACKGROUND

Generally, a radio communication system of today comprises a radio access network and a number of communication devices. The radio access network is built up of several nodes, in particular, radio base stations. The primary task of a radio base station is to send and receive information to/from the communication devices within a cell served by the radio base station. In many cases, the base station is run 24 hours a day. Therefore, it is of particular interest and importance to ensure that the base station is operable predictably and reliably. The radio base station further comprises a cabinet, which comprises an enclosure for housing circuitry, or electronic equipment, for performing different tasks of the radio base station. For example, the circuitry may comprise a power control unit, a radio unit, comprising a radio amplifier, and a filtering unit for performing corresponding tasks.

Due to low efficiency in the radio amplifier of the radio base station, heat generated in the circuitry of the base station, in particular the radio unit, may not always dissipate naturally to a sufficiently high degree. Instead, heat is accumulated in the circuitry and temperature of the circuitry increases. The increased temperature of the circuitry may decrease the performance of circuitry within the radio base station, e.g. the circuitry within the radio base station may fail. Consequently, unpredicted interruptions in operation of the base station may occur. This is clearly not desired.

Hence, as is known in the art, systems for cooling of heat generating equipment within a radio base station have been developed. These systems are sometimes referred to as climate systems or climate control systems for radio base stations.

An example of such a system for cooling of heat generating equipment is described below. The system comprises fans, which are used to circulate air through or over the heat generating equipment and through or over one side of a heat exchanger, i.e. an internal side within the enclosure. Moreover, further fans are used to force ambient air through or over the other side of the heat exchanger, i.e. an external side within the cabinet. The heat exchanger comprises a refrigerant that absorbs heat from air, heated by the electronic equipment, at the internal side within the enclosure. As a result, a transition from liquid phase to gas phase of the refrigerant occurs. The portion of the heat exchanger that is located at the internal side within the enclosure is called evaporator. The gas is forced to the external side of the heat exchanger, where it dissipates heat to ambient air. As a result, a transition from gas phase to liquid phase of the refrigerant occurs in the external side of the heat exchanger. The portion of the heat exchanger that is located on the external side is called condenser. At this stage, gravity forces the liquid to flow towards the evaporator. This kind of heat exchanger is generally denoted a thermosiphon.

A disadvantage with this kind of system, which comprises a thermosiphon, is that the electronic equipment may become unnecessary cold during, for example, cold weather conditions. As a result, performance of the electronic equipment is impaired.

WO 99/30091 discloses a thermosiphon system with a controllable refrigeration capacity comprising a refrigerant medium container connected to the fall pipe containing the condensed refrigerant medium via a branch pipe and a heater in thermal contact with the container for regulating the amount of refrigerant medium in the thermosiphon system.

### SUMMARY

It is an object of the present invention to provide a system with a more reliable temperature regulation of the electronic equipment.

According to a first aspect of the invention, the object is achieved by a system in a radio network node for regulating temperature of electronic equipment within the radio network node according to claim 1.

According to a second aspect of the present invention, the object is achieved by an arrangement for restricting flow in a heat exchanger unit according to claim 5.

An idea of the invention is to reduce flow in the heat exchanger unit, whereby heat transportation to and/or from the electronic equipment via the first and second fluid is reduced. This is achieved by the system according to appended independent claim 1 and by the arrangement according to appended independent claim 5 by means of arranging a heater unit at the first pipe. In this manner, the system and the arrangement provide regulation of temperature of the electronic equipment without addition of any movable mechanical parts, such as valves or the like. As a result, a reliable system and a reliable arrangement are provided.

Advantageously, the heater unit provides for flow regulation of the second fluid while maintaining the same level of risk for leakage as before introduction of the heater unit.

Moreover, the heater unit maintains the same level of flow resistance in the heat exchanger as before introduction of the heater unit. In other words, the heater unit does not introduce any pressure drop between the condenser unit and the evaporator unit.

A further advantage with the proposed solution is that heater units are readily and commercially available at low costs.

It is to be understood that the network node may be a radio base station or any other kind of node in a (radio) communication system, which node comprises heat generating electronic equipment. Examples of other kinds of nodes are transmission nodes, remote subscriber switches (RSS) and nodes with similar functionality.

Further features of, and advantages with, the present invention will become apparent when studying the appended claims and the following description. Those skilled in the art realize that different features of the present invention may be combined to create embodiments other than those described in the following, without departing from the scope of the present invention, as defined by the appended claims.

### BRIEF DESCRIPTION OF THE DRAWINGS

The various aspects of the invention, including its particular features and advantages, will be readily understood from the following detailed description and the accompanying drawings, in which:
Fig. 1 shows a schematic block diagram of a system according to embodiments of the present invention, and
Fig. 2 shows a schematic block diagram of an arrangement comprising the heat exchanger unit in the system of Fig. 1.

### DETAILED DESCRIPTION

Throughout the following description similar reference numerals have been used to denote similar elements, parts, items or features, when applicable.

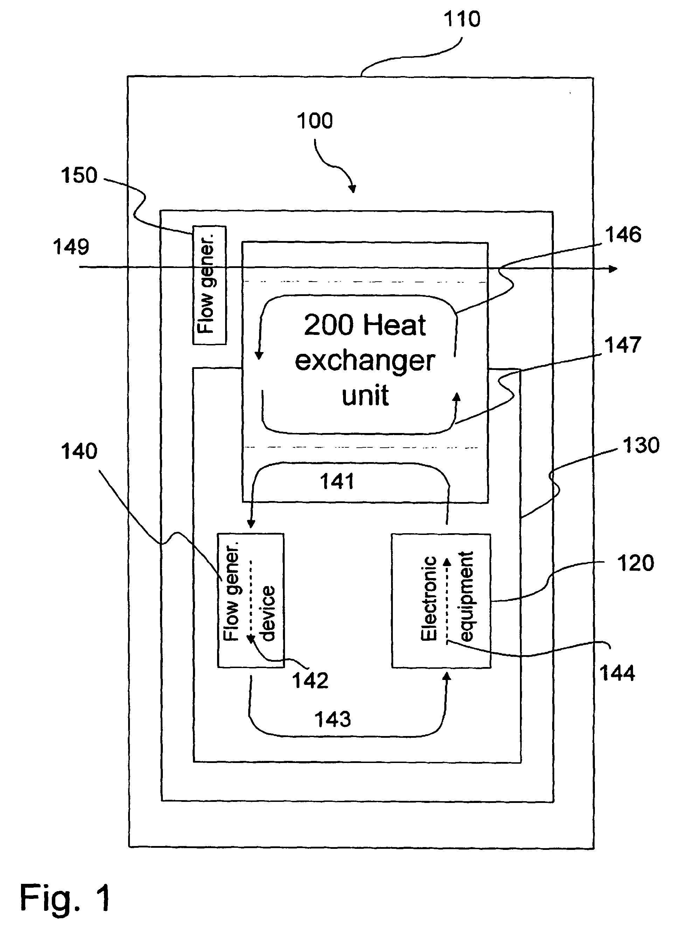

Fig. 1. shows a cross sectional, side view of a system 100 according to embodiments of the present invention. The system 100 in a radio network node 110 for regulating temperature of electronic equipment 120 within the radio network node 110 comprises a closed space 130, comprising a flow generating device 140 and the electronic equipment 120. The flow generating device 140 is arranged to circulate, as indicated by arrows 141, 142, 143, 144, a first fluid within the closed space 130 such that heat is transferrable between the electronic equipment 120 and the first fluid. The arrow 144, in the vicinity of the electronic equipment 120, is dashed to indicate that the flow of the first fluid may pass through or over the electronic equipment 120. The arrow 142, at the flow generating device 140, is dashed to indicate that the flow is passed through the flow generating device 140. The system 100 further comprises a heat exchanger unit 200 arranged to transfer heat from the first fluid within the closed space 130 to ambient air outside the closed space 130. Optionally, a flow generating device 150 may be arranged to push or to direct ambient air through or over, as indicated by arrow 149, a portion of the heat exchanger 200 that is located outside the closed space 130. In this manner, excess heat from the electronic equipment 120 may be transported from the electronic equipment 120 to the first fluid within the closed space 130, from the first fluid to a second fluid comprised in and circulated within, as indicated by arrows 146, 147, the heat exchanger 200, and from the second fluid to, for example, ambient air.

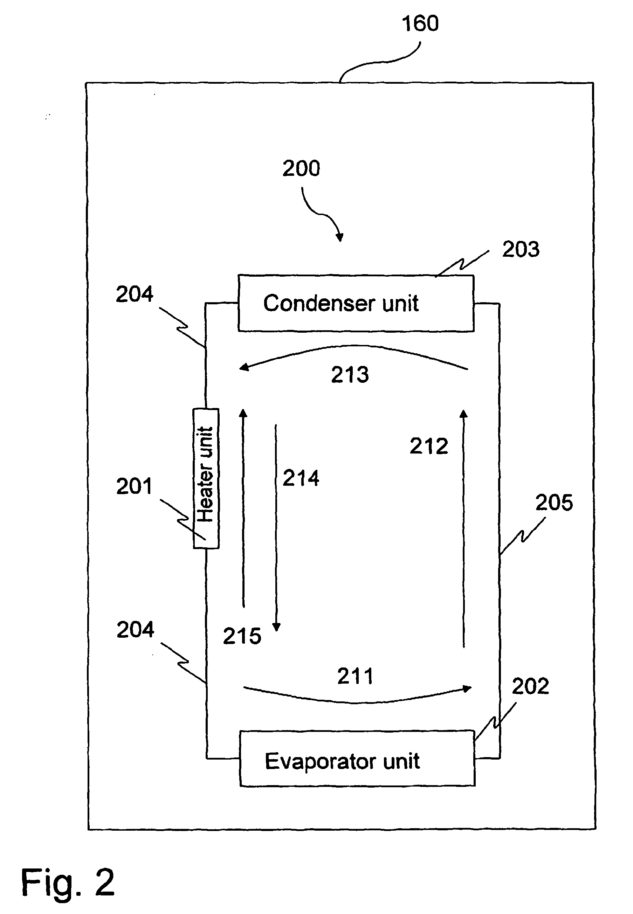

Now with reference to Fig. 2, there is illustrated a block diagram of an arrangement 160 comprising the heat exchanger unit 200 in the system 100 according to Fig. 1. The heat exchanger unit 200 comprises an evaporator unit 202, a condenser unit 203, and a first and a second pipe 204, 205. The evaporator unit 202 is at least partly located within the closed space and the condenser unit 203 is at least partly located outside the closed space. The first and second pipes 204, 205 are arranged to connect the evaporator unit 202 and the condenser unit 203, whereby a loop is formed. A second fluid, such as a refrigerant fluid or a coolant, is flowable from the condenser unit 203 to the evaporator unit 202 in the first pipe 204 and from the evaporator unit 202 to the condenser unit 203 in the second pipe 205. The arrangement 160 comprises a heater unit 201 arranged at the first pipe 204 and arranged to heat the second fluid in the first pipe 204 such that flow in the first pipe 204 is restricted. By restricting the flow in the first pipe 204 performance of the heat exchanger unit 200 is decreased. As a consequence, the temperature of the first fluid within the closed space 130 is increased. Hence, also temperature of the electronic equipment 120 is increased, i.e. temperature of the electronic equipment 120 is regulated. Since the second fluid in the first pipe 204 has a temperature that is close to saturation point (boiling point) of the second fluid, only a small amount of heat is needed in order to evaporate the second fluid. The evaporated second fluid, in gaseous phase, causes a flow in the opposite direction to the flow of condensed second fluid, in liquid phase, in the first pipe 204. Consequently, due to the counteracting flows in gaseous and liquid phase, respectively, speed of flow in the loop is decreased or even completely shut off.

When operating the system 100 of Fig. 1 the following steps are performed simultaneously or as a sequence, starting with any of the steps described below. As a first step, as indicated by arrow 211, the evaporator unit 202 evaporates the second fluid. As a result, a first flow, as indicated by arrow 212, of the second fluid from the evaporator unit 202 to the condenser unit 203 is generated. Next, the condenser unit 203 condenses, as indicated by arrow 213, the second fluid. Thereby, a second flow, as indicated by arrow 214, of the second fluid from the condenser unit 203 to the evaporator unit 202 is generated. The second flow is enhanced by gravitation. In a further step, the heater unit 201 heats the second fluid in the first pipe 204. Since the temperature of the second fluid is close to saturation point of the second fluid, only a small amount of heat transferred to the second fluid causes the second fluid to evaporate. As a result, a third flow, as indicated by arrow 215, of the second fluid is generated. In this manner, the third flow, which is directed in the opposite direction compared to the flow of the second fluid in liquid phase from the condenser unit 203 to the evaporator unit 202, reduces the overall flow of the second fluid in the loop. Consequently, the reduced overall flow of the second fluid in the loop reduces the amount of heat transferred between the electronic equipment and the second fluid. Hence, for example, cooling of the electronic equipment is reduced.

It may be noted that the heater unit may, alternatively or additionally, be arranged to heat the first pipe, which in turn heats the second fluid therein.

As mentioned above, the flow of the second fluid in the heat exchanger unit 200 indirectly affects the amount of heat transferred to and/or from the electronic equipment. Thus, in a still further step, the heater may, optionally, be controlled by a controller (not shown), whereby temperature of electronic equipment comprised in the radio network node may be controlled.

Moreover, in some embodiments of the system according to the present invention, the heat exchanger unit 200 comprises a thermosiphon. It is preferred that resistance of or air pressure difference over the thermosiphon is low. Advantageously, the flow generating device 140 may be operated at low power, i.e. the system may be energy efficient. However, sometimes undesired flows of ambient air through the heat exchanger (see arrow 149) may cause the heat exchanger to cool the electronic equipment 120 more than desired. The undesired flows of ambient air are generated by and dependent on external weather conditions. For example, a windy day may cause undesired cooling of the electronic equipment 120. The provision of a heater unit 201, as described above, allows for a reduction of (or possibly complete shut off of) the amount of heat transferred from the electronic equipment 120, thereby securing that operation of the electronic equipment 120 is not impaired.

In embodiments of the system according to the present invention, the condenser unit 203 is located at least partly above the evaporator unit 202. Expressed differently, the evaporator unit 202 and the condenser unit 203 are arranged in relation to each other such that the fluid thanks to gravity is passed from the condenser unit 203 to the evaporator unit 202. As a result, fluid evaporated in the evaporator unit 202 is allowed to pass upwards and fluid condensed in the condenser unit 203 is allowed to pass downwards, in accordance with commonly known principles of fluid dynamics.

In an example of the system according to embodiments of the present invention, the electronic equipment 120 and the flow generating device 140 are arranged such that heat is transferrable between the electronic equipment 120 and the first fluid, wherein the flow generating device 140 is arranged to circulate the first fluid within the closed space 130. More specifically, not shown in a Figure, the flow generating device 140 may be arranged next to and at the same level from ground as the heat exchanger unit 200 in an upper portion of the enclosed space 130. Alternatively, the flow generating device 140 may be arranged next to and at the same level from ground as the electronic equipment 120 in a lower portion of the enclosed space 130, while the heat exchanger unit 200 still is located in an upper portion of the enclosed space 130. A man skilled in the art may find other alternatives for arranging the electronic equipment 120 and the flow generating device 140 such that heat is transferrable between the electronic equipment 120 and the first fluid.

## Claims

1. A system (100) in a radio network node (110) for regulating temperature of electronic equipment (120) within the radio network node (110), the system (100) comprising
a closed space (130) comprising a flow generating device (140) and the electronic equipment (120), wherein the flow generating device (140) is arranged to circulate (141, 142, 143, 144) a first fluid within the closed space (130) such that heat is transferrable between the electronic equipment (120) and the first fluid, and
a heat exchanger unit (200), comprising an evaporator unit (202), a condenser unit (203), and a first and a second pipe (204, 205), wherein the evaporator unit (202) is at least partly located within the closed space, the condenser unit (203) is at least partly located outside the closed space, the first and second pipes (204, 205) are arranged to connect the evaporator unit (202) and the condenser unit (203), thereby forming a loop, and wherein a second fluid is flowable from the condenser unit (203) to the evaporator unit (202) in the first pipe (204) and from the evaporator unit (202) to the condenser unit (203) in the second pipe (205), the system further comprising
a heater unit (201) arranged at the first pipe (204) and arranged to heat the second fluid in the first pipe (204), wherein the heater unit (201) evaporates the second fluid in the first pipe in order to create in the first pipe (204) a flow (215) of evaporated second fluid in gaseous phase in opposite direction to the flow of condensed second fluid (214) in liquid phase so as to provide a flow regulation of the second fluid in the first pipe (204) and to regulate the temperature of the electronic equipment (120).

2. The system (100) according to any one of the preceding claims, wherein the second fluid is a refrigerant fluid.

3. The system (100) according to any one of the preceding claims, wherein the heat exchanger unit (200) comprises a thermosiphon.

4. The system (100) according to any one of the preceding claims, wherein the network node (110) is a radio base station.

5. An arrangement (160) for restricting flow in a heat exchanger unit (200) used for regulating temperature of an electronic equipment, the arrangement comprising an evaporator unit (202), a condenser unit (203), and a first and a second pipe (204, 205), the first and second pipes (204, 205) are arranged to connect the evaporator unit (202) and the condenser unit (203), thereby forming a loop, and wherein a second fluid is flowable from the condenser unit (203) to the evaporator unit (202) in the first pipe (204) and from the evaporator unit (202) to the condenser unit (203) in the second pipe (205), the arrangement (160) comprising
a heater unit (201) arranged at the first pipe (204) and arranged to heat the second fluid in the first pipe (204), wherein the heater unit (201) evaporates the second fluid in the first pipe in order to create in the first pipe (204) a flow (215) of evaporated second fluid in gaseous phase in opposite direction to the flow of condensed second fluid (214) in liquid phase so as to provide a flow regulation of the second fluid in the first pipe (204) and to regulate the temperature of the electronic equipment (120).

## Patentansprüche

1. System (100) in einem Funknetzwerkknoten (110) zum Regulieren der Temperatur von elektronischer Ausrüstung (120) innerhalb des Funknetzwerkknotens (110), wobei das System (100) umfasst:
einen geschlossenen Raum (130), der eine durchflusserzeugende Vorrichtung (140) und die elektronische Ausrüstung (120) umfasst, worin die durchflusserzeugende Vorrichtung (140) dafür eingerichtet ist, ein erstes Fluid innerhalb des geschlossenen Raums (130) zirkulieren zu lassen (141, 142, 143, 144), so dass Wärme zwischen der elektronisches Ausrüstung (120) und dem ersten Fluid übertragbar ist, und
eine Wärmetauschereinheit (200), die eine Verdampfereinheit (202), eine Verflüssigereinheit (203) und ein erstes und ein zweites Rohr (204, 205) umfasst, worin die Verdampfereinheit (202) zumindest teilweise innerhalb des geschlossenen Raumes angeordnet ist, die Verflüssigereinheit (203) zumindest teilweise außerhalb des geschlossenen Raumes angeordnet ist, das erste und zweite Rohr (204, 205) dafür eingerichtet sind, die Verdampfereinheit (202) und die Verflüssigereinheit (203) zu verbinden, wodurch sie eine Schleife bilden, und worin ein zweites Fluid von der Verflüssigereinheit (203) zur Verdampfereinheit (202) im ersten Rohr (204) und von der Verdampfereinheit (202) zur Verflüssigereinheit (203) im zweiten Rohr (205) fließfähig ist, wobei das System ferner umfasst:
eine Heizungseinheit (201), die am ersten Rohr (204) angeordnet ist und dafür eingerichtet ist, das zweite Fluid im ersten Rohr (204) zu erwärmen, worin die Heizungseinheit (201) das zweite Fluid im ersten Rohr verdampft, um im ersten Rohr (204) einen Fluss (215) von verdampftem zweitem Fluid in Gasphase in entgegengesetzter Richtung zum Fluss (214) von kondensiertem zweitem Fluid in Flüssigphase zu erzeugen, um dadurch eine Flussregulierung des zweiten Fluids im ersten Rohr (204) bereitzustellen und die Temperatur der elektronischen Ausrüstung (120) zu regulieren.

2. System (100) nach Anspruch 1, worin das zweite Fluid ein Kältemittelfluid ist.

3. System (100) nach einem der vorhergehenden Ansprüche, worin die Wärmetauschereinheit (200) einen Thermosiphon umfasst.

4. System (100) nach einem der vorhergehenden Ansprüche, worin der Netzwerkknoten (110) eine Funkbasisstation ist.

5. Anordnung (160) zum Begrenzen des Flusses in einer Wärmetauschereinheit (200), die zum Regulieren der Temperatur einer elektronischen Ausrüstung verwendet werden, wobei die Anordnung eine Verdampfereinheit (202), eine Verflüssigereinheit (203) und ein erstes und ein zweites Rohr (204, 205) umfasst, wobei das erste und zweite Rohr (204, 205) dafür eingerichtet sind, die Verdampfereinheit (202) und die Verflüssigereinheit (203) zu verbinden, wodurch sie eine Schleife bilden, und worin ein zweites Fluid von der Verflüssigereinheit (203) zur Verdampfereinheit (202) im ersten Rohr (204) und von der Verdampfereinheit (202) zur Verflüssigereinheit (203) im zweiten Rohr (205) fließfähig ist, wobei die Anordnung (160) umfasst:
eine Heizungseinheit (201), die am ersten Rohr (204) angeordnet ist und dafür eingerichtet ist, das zweite Fluid im ersten Rohr (204) zu erwärmen, worin die Heizungseinheit (201) das zweite Fluid im ersten Rohr verdampft, um im ersten Rohr (204) einen Fluss (215) von verdampftem zweitem Fluid in Gasphase in entgegengesetzter Richtung zum Fluss (214) von kondensierten zweitem Fluid in Flüssigphase zu erzeugen, um dadurch eine Flussregulierung des zweiten Fluids im ersten Rohr (204) bereitzustellen und die Temperatur der elektronischen Ausrüstung (120) zu regulieren.

## Revendications

1. Système (100) dans un noeud de réseau radio (110) pour réguler la température d'un équipement électronique (120) au sein du noeud de réseau radio (110), le système (100) comprenant :
un espace clos (130) comprenant un dispositif de génération de flux (140) et l'équipement électronique (120), dans lequel le dispositif de génération de flux (140) est agencé de manière à faire circuler (141, 142, 143, 144) un premier fluide au sein de l'espace clos (130), de sorte que de la chaleur peut être transférée entre l'équipement électronique (120) et le premier fluide ; et
une unité d'échangeur thermique (200), comprenant une unité d'évaporateur (202), une unité de condenseur (203), et des premier et second tuyaux (204, 205), dans lequel l'unité d'évaporateur (202) est au moins partiellement située à l'intérieur de l'espace clos, l'unité de condenseur (203) est au moins partiellement située à l'extérieur de l'espace clos, les premier et second tuyaux (204, 205) sont agencés de manière à connecter l'unité d'évaporateur (202) et l'unité de condenseur (203), formant ainsi une boucle, et dans lequel un second fluide pleut s'écouler de l'unité de condenseur (203) vers l'unité d'évaporateur (202) dans le premier tuyau (204), et de l'unité d'évaporateur (202) vers l'unité de condenseur (203) dans le second tuyau (205), le système comprenant en outre :
une unité de réchauffeur (201) agencée au niveau du premier tuyau (204), et agencée de manière à chauffer le second fluide dans le premier tuyau (204), dans lequel l'unité de réchauffeur (201) évapore le second fluide dans le premier tuyau de créer, dans le premier tuyau (204), un flux (215) de second fluide évaporé en phase gazeuse dans une direction opposée à celle du flux de second fluide condensé (214) en phase liquide, de manière à fournir une régulation de flux du second fluide dans le premier tuyau (204) et à réguler la température de l'équipement électronique (120).

2. Système (100) selon la revendication 1, dans lequel le second fluide est un fluide frigorigène.

3. Système (100) selon l'une quelconque des revendications précédentes, dans lequel l'unité d'échangeur thermique (200) comporte un thermosiphon.

4. Système (100) selon l'une quelconque des revendications précédentes, dans lequel le noeud de réseau (110) est une station de base radio.

5. Agencement (160) destiné à limiteur un flux dans une unité d'échangeur thermique (200) utilisée pour réguler la température d'un équipement électronique, l'agencement comprenant une unité d'évaporateur (202), une unité de condenseur (203), et des premier et second tuyaux (204, 205), les premier et second tuyaux (204, 205) sont agencés de manière à connecter l'unité d'évaporateur (202) et l'unité de condenseur (203), formant ainsi une boucle, et dans lequel un second fluide pleut s'écouler de l'unité de condenseur (203) vers l'unité d'évaporateur (202) dans le premier tuyau (204), et de l'unité d'évaporateur (202) vers l'unité de condenseur (203) dans le second tuyau (205), l'agencement (160) comprenant :
une unité de réchauffeur (201) agencée au niveau du premier tuyau (204), et agencée de manière à chauffer le second fluide dans le premier tuyau (204), dans lequel l'unité de réchauffeur (201) évapore le second fluide dans le premier tuyau afin de créer, dans le premier tuyau (204), un flux (215) de second fluide évaporé en phase gazeuse dans une direction opposée à celle du flux de second fluide condensé (214) en phase liquide, de manière à fournir une régulation de flux du second fluide dans le premier tuyau (204) et à réguler la température de l'équipement électronique (120).
